**Europäisches Patentamt**

**European Patent Office**

**Office européen des brevets**

(19)

(11) Publication number: **O 003 363**

**B1**

(12)

# EUROPEAN PATENT SPECIFICATION

(45) Date of publication of patent specification: **01.12.82**

(21) Application number: **79100263.7**

(22) Date of filing: **30.01.79**

(51) Int. Cl.³: **H 05 K 3/24, H 05 K 3/10, H 05 K 3/18, H 05 K 3/00, G 03 C 5/00, G 03 F 7/20**

(54) Producing printed circuits by soldering metal powder images.

(30) Priority: **01.02.78 US 874352**

(43) Date of publication of application:
**08.08.79 Bulletin 79/16**

(45) Publication of the grant of the patent:
**01.12.82 Bulletin 82/48**

(84) Designated Contracting States:
**BE DE FR GB NL**

(56) References cited:
**GB - A - 1 429 082**
**NL - A - 278 021**
**US - A - 3 506 482**

(73) Proprietor: **E.I. DU PONT DE NEMOURS AND COMPANY**
**Legal Department 1007 Market Street**
**Wilmington Delaware 19898 (US)**

(72) Inventor: **Cohen, Abraham Bernard**
**33 Hemlock Terrace**
**Springfield New Jersey 07081 (US)**
Inventor: **Peiffer, Robert William**
**2 Quincy Drive**
**Jackson New Jersey 08527 (US)**

(74) Representative: **von Kreisler, Alek, Dipl.-Chem. et al,**
**Deichmannhaus am Hauptbahnhof**
**D-5000 Köln 1 (DE)**

Courier Press, Leamington Spa, England.

## Technical field

This invention relates to a new additive method for preparing printed circuits including multilayer printed circuits, and pertains more particularly to the preparation of printed circuits by soldering metallized areas. This invention also relates to new printed circuit elements.

## Background art

Powdered materials such as metal particles have been applied to surfaces having image-wise tacky and non-tacky areas by a number of toning methods to produce printed circuit patterns. Representative methods are disclosed in U.S. Patents 3,060,024; 3,391,455; 3,506,483; 3,637,385; 3,649,268; 4,054,479; and 4,054,483. After the metal particles are applied to the tacky image areas and unwanted particles are removed, e.g., mechanically, from the non-tacky image areas, the circuit is formed by one of several additive techniques including fusion of metal particles, electroless plating, electroplating, etc. The printed circuits formed by these additive processes are useful, but the processes have certain disadvantages. For example, they are time consuming, costly, require high temperatures or pH and skilful operators, and are difficult to automate. It is also difficult by some of these processes to prepare certain printed circuits, particularly circuits having a fine conductive wiring trace. The above disadvantages have been overcome by a process whereby printed circuits containing electrically conductive circuit traces can be produced almost instantly and in an automated procedure without costly and lengthy treatment such as electroless plating.

## Disclosure of invention

In accordance with this invention, a process for producing a printed circuit containing an electrically conductive circuit trace is produced from a material having adherent and non-adherent surface areas which comprises applying finely divided, solder wettable, metal or alloy particles to the surface areas; removing any excess metal or alloy particles from the non-adherent areas is characterized in that particulate metallized areas are treated with solder flux and subsequently with molten solder to form a soldered electrically conductive circuit.

A printed circuit element so produced comprises, in order, (a) a substrate; (b) an imaged layer, at least about 0.00005 inch (0.0013 mm) in thickness, of an image photoadhesive composition having adherent and non-adherent surface areas; (c) finely divided, solder wettable, metal or alloy particles solely in the adherent image areas; and (d) a layer of solder adhered to the areas having the metal or alloy particles.

The printed circuit substrates employed in the present invention can be any one of the various kinds of sheets, plates, synthetic resin plates, synthetic resin laminated plates or composites, etc., having the necessary electrical and mechanical properties, chemical resistance, heat resistance, etc. Examples of resins include: phenolformaldehyde, epoxy and melamine resins, etc. Glass plates, ceramic or ceramic coated metal plates are also useful. The substrate can also be a paper, cardboard, fiber, including glass cloth, wooden sheet material or paper base phenolic resin laminate. Paper base without resin is particularly useful in producing low cost printed circuits. Metal sheets, e.g., with holes, can be used provided that a material adhered thereto acts as a barrier between the metal sheet support and the built-up metallized circuit. Also useful are self-supported photohardenable elements as disclosed in U.S. Patent 4,054,479.

A material that is adherent or tacky or capable of being made adherent by a suitable treatment, e.g., heating or chemical treatment, is applied in the form of a liquid or a solid layer to the surface of the substrate or circuit board. One type of adherent material that is useful is an adhesive which may be painted on the circuit board in the form of the desired electrical circuit. Silk screen printing techniques such as are described in Printed Circuits Handbook, C. F. Coombs, Jr., Editor, McGraw-Hill, Inc., New York, New York, 1967, pages 4-25 to 4-37 are other means of applying adherent materials. Generally, in screen printing an ink is prepared in which suitable printing adaptability is imparted to the adhesive. The adhesive may be an epoxy resin, phenol resin, rubber phenol and polyvinyl butyral and may contain a filler such as a pigment, e.g., carbon, $TiO_2$, zinc oxide, etc. U.S. Patents 3,391,455 and 3,506,482 disclose adhesives that have excellent adhesive force, electrical properties and high resistance to heat and chemicals and describe methods of application of the adhesives to circuit boards. Suitable thicknesses for the adhesive ink is about 20 to 50 microns.

A preferred type of adherent material is a photoadhesive composition such as a photohardenable, photosoluble, or photodesensitizable composition in liquid form, e.g., solution, suspension, etc., which can be applied to a circuit board by conventional means, e.g., dip coating, spin coating, coating with a doctor knife, spraying, etc. or in the form of a dry layer. For the purposes of this invention a photoadhesive composition is a photosensitive composition which upon imagewise exposure to actinic light will form adherent image areas in either exposed or unexposed image areas either directly or after subsequent treatment of the composition. The photohardenable composition includes photopolymerizable layers capable of addition polymerization, photocrosslinkable layers, and photodimerizable layers. Many specific examples of such photohardenable layers are set forth in the following U.S. Patents which are incorporated herein by reference: 3,469,982; 3,526,504; 3,547,730; 3,060,024; 3,622,334; 3,649,268; and French Patent 72 11658. The photosoluble compositions disclosed in U.S. Patent 3,837,860 and the photodesensitizable compositions disclosed in U.S. Patent 3,778,270 are also useful.

A preferred element contains a photohardenable image-yielding stratum on a strippable support. The photohardenable composition is generally present in a dry coating thickness of about 0.00005 to about 0.10 inch (0.0013 to 2.54 mm) or more and preferably about 0.0003 inch (~0.0008 cm) to about 0.01 inch (~0.025 cm). A removable cover sheet may be present over the photohardenable layer. Photohardenable, e.g., photopolymerizable, layers and elements are more fully described in U.S. Patent 4,054,483, the disclosure of which is incorporated by reference. Photopolymerizable compositions generally contain at least one binder, ethylenically unsaturated monomers, initiators or initiator system, thermal polymerization inhibitors and other additives such as dyes, pigments, plasticizers, etc.

Once a photosensitive composition or layer is applied to the printed circuit substrate, it is exposed imagewise and either directly forms or can be rendered to form adherent and non-adherent image areas. Suitable radiation sources depend on the photosensitive composition type. Generally, however, radiation sources that are rich in ultraviolet radiation are useful. Radiation sources are disclosed in U.S. Patents 2,760,863 and 3,649,268. The exposure may be through a phototool, negative or positive, having the circuit image including circuit trace.

Solder wettable metal and alloy particles or combinations thereof are applied to the adherent and non-adherent image areas to produce particulate, metallized, adherent image areas. Suitable particles include: copper, and copper alloys, e.g., copper-tin alloy; tin-lead alloy; aluminum; gold; silver; nickel and nickel alloys; lead and tin that are solder wettable. Also useful are metal coated particles, e.g., silver-coated glass. Copper powder is preferred because of its high conductivity and low cost. The particles have an average diameter of about 0.5 to 250 microns, 5 to 20 microns in average diameter being a preferred particle size. Mixed particle sizes can be used including larger sized particles followed by smaller particles. A more preferred average particle diameter is 8 to 11 microns.

The particles can be applied by known methods, including, but not limited to, the toning methods described in the patents listed in the "Background art" section and U.S. Patents 3,391,455 and 3,506,482. Another useful application technique is by use of a fluidized bed of particles, *Research Disclosure*,

June 1977, No. 15882 by Peiffer and Woodruff. It is important that any excess metal or alloy particles which may be present be removed from the non-adherent or non-tacky image areas. In some embodiments, excess particles are not present or, if present, may be removed during the soldering operation. Suitable mechanical and other means for removing excess particles are described in the above-mentioned U.S. patents and Research Disclosure.

Although a short heating period is preferred to rapidly improve adhesion of metal particles to the adherent image surfaces, other method may be used. In some instances, the substrate with the particulate metallized image thereon may simply be held at room temperature for a period of time, e.g., overnight, or pressure may be applied to the particulate image. In other instances, the imaged photoadhesive material may be treated with a volatile solvent or plasticizer for adherent image areas either before, during or after the solder-wettable metal particles are applied. When photoadhesion is improved by such liquid treatment further curing or hardening steps may not be necessary as exemplified in Example 11 below. Preferably, however, the particulate metallized areas are subsequently hardened or cured by heating, by exposing to actinic radiation, by treating with a suitable hardening or curing catalyst or reagent or other such methods known to those skilled in the art. While the preferred hardening or curing step generally precedes application of molten solder, the hardening or curing reaction in some instances may be combined with and occur concurrently with the soldering operation. Heating can be carried out by baking, e.g., at about 170°C or less, or by such radiative heating from infrared or microwave sources. The heating temperature must be below the degradation temperature of the adherent composition. The curing or hardening may be accelerated by prior treatment with a suitable catalyst or reagent which may be present on the metal particles or in the solder flux or may be applied independently. When the metallized material or area is photohardenable, it may be hardened by uniform exposure of the metallized element to actinic radiation preferably after a short heating period, e.g., 10 to 100 seconds at about 150° to 180°C, as exemplified in Example 4. The hardening step is dependent on many variables such as the composition used to form the adherent image and its reactivity to heat, light or reagents, the thickness of the applied composition, the mode and conditions of applying hardening energy, etc.

Prior to soldering, the metallized areas are treated by known procedures with solder fluxes typified by the following compositions:

Rosin type, organic, e.g., a mixture of diterpene acids in alcohol, water, or other appropriate solvent;

Inorganic acids, e.g., HCl, orthophosphoric acid, etc.;

Inorganic salts, e.g., zinc chloride, ammonium chloride and combinations thereof used to produce HCl upon heating in the presence of water;

Organic acids, e.g., lactic, citric, oleic, etc.;

Organic halogen compounds, e.g., aniline hydrochloride, etc.;

Organic amines and amides, e.g., urea, etc.

As indicated above, these fluxes can contain curing or hardening catalysts or reagents.

The fluxed image areas are subsequently exposed to molten solder, e.g., solder waves, etc. Known solder compositions can be used, e.g., tin, lead combinations, and compositions containing bismuth, cadmium, indium, silver and antimony. When the adherent material is thermally stable, low melting metals alone may be used, e.g., tin, lead, indium, etc. Preferred solders particularly useful in the preparation of printed circuits are tin/lead in ratios of 63/37 and 60/40. It is important to balance the ability to solder with the adhesion of the metal particles in the adherent image areas, e.g., the areas should be tacky enough to adhere the metal particles but not too tacky whereby the particles would become coated or engulfed with the tacky material.

Best mode for carrying out the invention

The best mode for carrying out the invention is as follows: A film supported photopolymerizable layer as described in Example 4 is laminated to a glass-epoxy based printed circuit board also as described in Example 4. The photopolymerizable layer is exposed through a photographic positive circuit pattern for 10 seconds to the ultraviolet radiation source described in Example 1. After removing the support, copper powder, 8 microns in average diameter, is applied in a fluidized bed. The board is heated for 30 seconds at 160°C (external reading), and the excess copper is removed by brushing. The metallized board is passed through the ultraviolet exposure source described in Example 4. The circuit pattern is brushed with an aqueous solder flux as described in Example 5 and is soldered as described in that Example at 16 feet/minute (48.77 m/minute). A highly conductive printed circuit element is obtained.

Industrial applicability

The process of this invention is easily adapted to automation and is applicable to the preparation of fine conductive wiring traces, and low cost printed circuits. The process is also useful in preparing multilayer circuits by using previously prepared printed circuits as the substrate in the process of this invention as described above and/or repeating the operations of the process with additional layers of photoadhesive material adhered to each successive underlying printed circuit and exposing in register with an appropriate phototool for the successive layer. Through-holes can be introduced at appropriate junctures to permit electrical connecting between layers and/or allow insertion of electrical components to be soldered into the finished boards. Through-holes may be introduced into the boards by conventional methods used in fabricating multilayer printed circuits. Stepwise, a procedure for preparing multilayer circuits is as follows:

(1) applying a photoadhesive layer to a previously prepared printed circuit board,

(2) exposing the photoadhesive layer to actinic radiation through an appropriate phototool in register with the underlying printed circuit,

(3) applying finely divided solder wettable metal or alloy particles to the adherent image areas,

(4) removing any excess metal or alloy particles from the non-adherent image areas, and

(5) treating the particulate metallized surface with solder flux and subsequently with molten solder to obtain a two-layer multilayer circuit.

Additional circuit layers are added by repeating steps (1) through (5) using an appropriate phototool in register with at least one of the underlying printed circuits in each step (2). Similarly double-sided multilayer circuit boards may be produced by carrying out steps (1) through (5) one or more times on each side of a previously prepared double-sided printed circuit board.

If interconnections are desired between two or more of the layers, the soldered circuit of step (5) above can be further processed as follows:

(6) drilling or punching holes in the desired junction areas of the board;

(7) catalyzing the holes with a conventional solution of tin and palladium chlorides;

(8) cleaning the board to remove the catalyst from the board side surfaces; and

(9) electrolessly plating the conductive through-holes with metal to complete the electrical interconnections.

When the photoadhesive material is a photopolymerizable material or other oxygen-sensitive material, the imaging exposure may be carried out in an inert atmosphere, e.g., nitrogen, or the surface of the photoadhesive layer may be laminated with an oxygen-impermeable film cover sheet, e.g., polyester film, or may be coated with a layer that functions as a barrier to oxygen. In the instance when a film or barrier coating is used, the film or coating is removed before application of the finely divided particulate metal particles.

In the preferred process each particulate metallized layer is hardened or cured either before or during the soldering step (5) as previously described.

The photoadhesive material may be applied by either laminating a film element directly to the previously prepared circuit board or the board may be coated with a solution of the material and dried. Such a laminating procedure may be by a process analogous to Example 4 of U.S. Patent 4,054,483 wherein direct soldering of metallized powder images would replace electroless plating.

The coating procedure is also useful in preparing multilayer circuits which are connected by through-holes. The preparation of such multilayer circuits is illustrated by Example 2. Stepwise, such a procedure for preparing multilayer circuits is as follows:

1. holes are drilled or punched in a previously double-sided printed circuit board with or without plated through-holes;

2. the board, including hole walls, is coated with a solution or suspension of photopolymer composition;

3. each board side is laminated with a film cover sheet, e.g., polyester film, or is coated with a solution that functions as a barrier to oxygen;

4. each side of the board is exposed to actinic radiation through an appropriate phototool;

5. each cover sheet or oxygen barrier layer is removed;

6. solder wettable metal powder, e.g., copper, is applied to the adherent unexposed image areas on both sides of the circuit board as well as to the hole walls;

7. the particulate metallized areas are hardened or cured by heating or uniformly exposing to actinic radiation; and

8. each metallized surface and through-holes are treated with solder flux and subsequently with molten solder to obtain a four-level multilayer circuit in which the two outerlayers are interconnected.

The prepared circuits of this invention can be covered with a solder mask composition and preferably a photosensitive flame retardant solder mask film. Subsequently, an adherent image can be made over the solder mask, and a circuit of the image can be made using the process of this invention. In some instances where the solder mask is photosensitive, the solder mask itself may be used to form an adherent image. An adherent image on either side of the prepared circuit may also be used to add visible nomenclature and/or graphics by toning adherent imge areas with suitable pigments. Useful toning procedures and elements are described in U.S. Patent 3,060,024; 3,620,726 and 3,649,268.

Examples

The invention will be illustrated by the following examples wherein the parts and percentages are by weight.

Example 1

A photopolymerizable composition containing the following ingredients:

| | |
|---|---|
| copolymer of methyl methacrylate (46%), acrylonitrile (9%), butadiene (14%), and styrene (31%) | 1,505 g |
| solid unsaturated urethane resin (M.W. ca. 1,900; 0.5% unsaturation) | 1,505 g |
| trimethylol propane triacrylate | 705 g |
| triethylene glycol diacrylate | 705 g |
| benzophene | 140 g |
| 4,4'-bis(dimethylamino)benzo-phenone | 140 g |
| methylene chloride | 8,770 g |

is coated on a 0.025 mm thick polyethylene terephthalate support, and the layer is dried to a thickness of about 0.038 to 0.51 mm. The photopolymerizable layer is laminated to a glass-epoxy base printed circuit board, and the photopolymerizable layer is exposed for 20 seconds through a photographic positive pattern to ultraviolet radiation of a 400 watt, medium pressure, mercury vapor lamp in a Model DMVL Double Sided Exposure Frame, a product of Colight, Inc., Minneapolis, Minn. The polyethylene terephthalate support is removed, and the photopolymerized surface is dusted with copper powder, less than 35 microns to more than 150 microns in average diameter, Fisher copper metal C-434 marketed by Fisher Scientific Co., Fair Lawn, New Jersey. The excess powder is removed in the exposed non-tacky areas with a fine water spray leaving a circuit pattern defined by the adherent copper powder. The metallized laminate is baked for 1 hour at 160° to 165°C and is brushed with a rosin type solder flux, Alpha®809, manufactured by Alpha Metals Inc., Jersey City, New Jersey. The fluxed laminate is passed over a solder wave, tin/lead (60/40), in a Model 201396 Wave Soldering Machine manufactured by Hollis Engineering, Inc., Nashua, New Hampshire. The solder adheres only to those regions where the copper powder is adherent to form a conductive printed circuit.

Example 2

Printed circuits are prepared on each side of two printed circuit boards as described in Example 1. Holes are drilled in the circuit boards and the boards, including the hole walls, are coated with the following photopolymer solution:

| | Parts |
|---|---|
| Copolymer of methyl meth-acrylate (46%), acrylonitrile (9%), butadiene (14%), and styrene (31%) | 33 |
| Trimethylol propane triacrylate | 16 |
| 2-tert-butyl anthraquinone | 1 |
| Toluene | 77 |
| Methylene chloride | 118 |

To each side of the coated circuit boards is laminated a polyethylene terephthalate film, 0.025 mm in thickness. Each side of the circuit boards is exposed for 60 seconds to the ultraviolet radiation source described in Example 1 through a circuit image. The polyethylene terephthalate films are removed and copper powder, 11 microns in average diameter, Alcan® MD 183 manufactured by Alcan Metal Powders, division of Alcan Aluminum Corp., Elizabeth, New Jersey, is applied to the unexposed regions on both sides and to the walls of the holes in each board and the excess copper powder is removed. The metallized circuit boards are baked for one hour at 160°— 165°C. The metallized areas including holes are brushed with the solder flux described in Example 1 and then are soldered using the solder procedure described in Example 1. Two four-level multilayer circuits in which the two outer layers are interconnected are obtained.

Holes are drilled in one of the multilayer circuit boards. The holes are catalyzed with a solution of tin and palladium chlorides and the board is washed with water to remove catalyst from both sides of the board. The board is electroless copper plated as described below to obtain conductive through-holes interconnecting the four circuit layers.

The prepared board is dipped for 30 seconds in a 20% by weight solution of sulfuric acid and then placed for 16 hours in an electroless copper plating bath, HiD–410 manufactured by Photocircuits Division, Kollmorgen Corp., Glen Cove, Long Island, New York.

The plating on the original printed circuit trace is good.

Example 3

On an insulating base phenolic resin laminate, an electrically conductive circuit trace is printed by a silk-screen printing process using an adhesive composition. The adhesive composition is prepared by adding to 30 g of epoxy resin consisting of Achmex® R-11 and 10 g of Achmex® H-85 3 g of carbon. Copper powder, 8 to 11 microns in average diameter, is dusted onto the layer of the adhesive to completely cover the adhesive print. A pressure of 0.5 to 1.0 g/cm² is applied thereon to have copper particles secured to the adhesive. The copper particles not secured to the adhesive are removed, and the adhesive is cured by heating at 150°±10°C for about 1 hour. The metallized image is brushed with the solder flux described in Example 1 and passed over a solder wave, tin/lead (63/37), using the Wave Soldering Machine described in Example 1. The solder adheres only to those regions where the copper powder is adherent to form a conductive printed circuit.

Example 4

A film supported photopolymerizable layer, 3 mils (~0.08 mm) in thickness, of the following composition:

| | Parts |
|---|---|
| Pentaerythritol triacrylate | 25.0 |
| Di-(2-acryloxyethyl) ether of tetrabromo Bisphenol-A | 10.0 |
| Di-(3-acryloxy-2-hydroxypropyl) ether of Bisphenol-A | 15.0 |
| Methyl methacrylate(46)/acrylonitrile(9)/butadiene-(14)/styrene(31) copolymer | 30.0 |
| Methyl methacrylate (95)/ethyl methacrylate(5) copolymer | 8.0 |
| Michler's ketone | 0.4 |
| Benzophenone | 5.3 |
| Antimony oxide (Sb₂O₃) | 6.0 |
| Monastral Green pigment | 0.3 |

is laminated at 105°C to a glass-epoxy base printed circuit board 31 mils (~0.79 mm) thick, and the polymerizable layer is exposed for 30 seconds through a photographic positive pattern and the support to ultraviolet radiation from the radiation source described in Example 1. The support is removed and the polymerized surface is dusted with copper powder, about 35 to 150 microns in average diameter, Fisher copper metal C-434, marketed by Fisher Scientific Company, Fair Lawn, New Jersey. The excess powder is removed by shaking the dusted board, and the board is heated for 1 minute at 160°C. The dusted circuit board is passed twice through a CTF Laminator, Model 1200, manufactured by E. I. du Pont de Nemours and Co., Inc., Wilmington, Delaware. The circuit pattern defined by the adhered copper powder is dusted with copper powder, 11 microns in average diameter, Alcan® MD-183 manufactured by Alcan Metal Powders division of Alcan Aluminum, Elizabeth, New Jersey. The excess copper powder is removed by shaking the dusted board, and the dusted board is heated for 1 minute at 160°C. The metallized board is passed twice through an ultraviolet exposure source at 10 ft/minute (3.05 m/minute), Model PC-7100 UV Processor, manufactured by Argus International, Hopewell, New Jersey to harden the photopolymer matrix. The circuit pattern defined by the adhered large and small copper powder is brushed with an aqueous solder flux, Alpha® 709-F, manufactured by Alpha Metals, Inc., Jersey City, New Jersey and then is passed over a solder wave in the wave soldering machine described in Example 1. A conductive solder printed circuit is obtained on the original printed circuit trace.

Example 5

A film supported photopolymerizable layer, as described in Example 4, is laminated to a glass-epoxy based printed circuit board also as described in Example 4. The photopolymerizable layer is exposed for 20 seconds through a photographic positive radio circuit pattern and the support to ultraviolet radiation from the radiation source described in Example 1. The support is removed and the polymerized surface is dusted with copper powder, about 11 microns in average diameter, as described in Example 2. The copper powder adheres to the unexposed image areas. The excess powder is removed by shaking the dusted board, and the board is heated for 30 seconds at 160°C (external reading). The metallized board is passed once through an ultraviolet exposure source as described in Example 4. The circuit pattern defined by the adherent copper powder is brushed with an aqueous solder flux, Alpha® 709-F, manufactured by Alpha Metals, Inc., Jersey City, New Jersey and then soldered with tin/lead (60/40) at 6 feet/minute (1.83 m/minute) using a wave solder unit manufactured by Hollis Engineering, Inc., Nashua, New Hampshire. Through holes are drilled in the board and components soldered to it. The radio works without problems.

Example 6

Example 5 is repeated with the following variations: the glass-epoxy based printed circuit board is replaced by a 0.062 inch (1.57 mm) thick paper base phenolic resin laminate, the surface of which is roughened. The lamination of the photopolymerizable layer is accomplished at 115°C in a vacuum laminator, Riston® A-1 Vacuum Laminator manufactured by E. I. du Pont de Nemours and Co., Inc., Wilmington, Delaware. Copper powder, about 8 microns in average diameter, Alcan® MD-301 manufactured by Alcan Metal Powders division of Alcan Aluminum, Elizabeth, New Jersey, is applied in a fluidized bed. After the excess copper powder is removed, the metallized board is heated for 50 seconds at 160°C. The radio works satisfactorily without problems.

Example 7

Example 6 is repeated except that a 10-ply cardboard Beveridge Paper Co., division Scott Paper, Indianapolis, Indiana, is used as the base circuit board, which is baked at 140°C for 1.5 hours and is vacuum laminated on both sides at 115°C with the photopolymerizable layer. The second side is entirely exposed. Resistance for a 0.1 inch (2.54 mm) wide soldered line for its length is zero, or equal to copper.

Example 8

A 0.031 inch (~0.79 mm) piece of pressboard (grey cardboard) is dipped for 30 seconds into a methylene chloride solution (20% solids) of the photopolymerizable composition described in Example 4 except that no pigment is present. The dipped self-supported board is air dried for 1 hour, is heated for 30 seconds in an infrared heater and is left in the open air at room temperature for two hours. After a polyethylene terephthalate film, 0.025 mm in thickness, is vacuum laminated to each surface, each side of the board is exposed through the laminated film to a positive circuit pattern for 30 seconds in the exposure source described in Example 1. Each laminated film is removed, and the exposed board is toned in a fluidized bed using the copper powder as described in Example 6. Excess copper powder is removed, the metallized board is heated and then is passed through an ultraviolet exposure source as described in Example 4 to expose each side. The circuit patterns defined by the adherent copper powder are fluxed as described in Example 5 and soldered by dipping in a tin/lead (60/40) solder mixture. Satisfactory soldered circuits are obtained.

Example 9

A 0.031 inch (~0.79 mm) piece of sheet steel is cleaned in a Model SBC-12F circuit board cleaning machine (Somaca®) and after drying is laminated with a film-supported photopolymerizable layer described in Example 4. The photopolymerizable layer is exposed for 15 seconds through a photographic positive pattern and the support to ultraviolet radiation from the radiation source described in Example 1. The film support is removed and copper powder is applied to the imaged layer as described in Example 6. The metallized board is heated for 30 seconds at about 150°C, cooled, and then brushed to remove excess copper. The metallized board is passed once through the ultraviolet exposure source as described in Example 4; the circuit pattern defined by the copper powder is brushed with an aqueous solder flux as described in Example 4, and then is passed over a solder wave tin/lead (63/37), using the wave soldering machine described in Example 1. The solder adheres only to those regions where the copper powder is adherent to form a circuit in which resistance between non-connected lines is greater than $2 \times 10^6$ ohms.

Example 10

A film supported photopolymerizable layer, as described in Example 4, is laminated to a glass-epoxy based printed circuit board also as described in Example 4. The photopolymerizable layer is exposed for 30 seconds through a photographic positive circuit pattern and the support to ultraviolet radiation from the radiation source described in Example 1. The support is removed and the polymerized surface is dusted with copper powder, about 11 microns in average diameter, as described in Example 2. The copper powder adheres to the unexposed image areas. The excess powder is removed by shaking the dusted board, and the board is allowed to stand for 24 hours at room temperature. The metallized board is passed twice through an ultraviolet exposure source as described in Example 4. The circuit pattern defined by the adherent copper powder is brushed with a rosin-type solder flux as described in Example 1 and is then soldered with tin/lead (60/40) at 6 feet/minute (1.83 mm/minute) using a wave solder unit manufactured by Hollis Engineering, Inc., Nashua, New Hampshire.

Example 11

A photopolymerizable element comprising a 0.01 inch (0.25 mm) thick metal support, an 0.018 inch (0.46 mm) thick cellulosic photopolymerizable layer, and a polyethylene terephthalate cover sheet is prepared, the cellulosic layer having the following composition:

|  | Parts |
|---|---|
| Cellulose hydroacetate | 36.0 |
| Cellulose acetate | 9.0 |
| Triethylene glycol diacrylate | 24.1 |
| Succinic anhydride | 13.8 |
| Tributoxyethyl phosphate | 13.0 |
| Glutaric acid | 1.0 |
| 2-ethylanthraquinone | 0.1 |
| Methyl ethyl hydroquinone | 0.18 |
| Diethylcyclohexyl amine | 3.0 |

The element is exposed through the cover sheet to a positive circuit image for 30 seconds by means of the exposure source described in Example 1. The cover sheet is removed, and the exposed element is dipped into ethyl Cellu-solve® (2-ethoxy ethanol), and the element is wiped to remove excess liquid. Copper powder, about 8 microns in average diameter, is applied as described in Example 6, and the excess copper powder is removed by brushing. After setting overnight, the circuit lines are fluxed with 5% by volume HCl, are wiped dry, and are wave soldered as described in Example 5. Lines of 0.10 inch (2.54 mm) and 0.02 inch (0.51 mm) are found to be highly conductive.

## Claims

1. A process for producing a printed circuit containing an electrically conductive circuit trace from a material having adherent and non-adherent surface areas which comprises applying finely divided, solder wettable, metal or alloy particles to the surface areas; removing any excess metal or alloy particles from the non-adherent areas; characterized in that the particulate metallized areas are treated with solder flux and subsequently with molten solder to form a soldered electrically conductive circuit.

2. A process according to Claim 1 wherein the particulate metallized areas are hardened or cured prior to or during treatment with molten solder.

3. A process according to Claim 2 wherein the particulate metallized areas are hardened or cured by heating, by exposing to actinic radiation or by treatment with a hardening or curing reagent.

4. A process according to Claim 1 wherein the particulate metallized areas are heated to less than 180°C before treatment with molten solder.

5. A process according to Claim 1 or 2 wherein the finely divided, solder wettable, metal or alloy particles have an average diameter of about 0.5 to about 250 microns.

6. A process according to Claim 1 wherein the metal particles are copper or a copper alloy.

7. A process according to Claim 1 wherein the adherent and non-adherent surface areas are tacky and non-tacky surface areas, respectively, and are present in an imaged layer of photoadhesive composition.

8. A process according to Claim 7 wherein the photoadhesive composition is a photohardenable composition taken from the group consisting of photopolymerizable, photocrosslinkable, and photodimerizable compositions.

9. A process for making a multilayer printed circuit board according to Claim 1 to 8 wherein the circuit board substrate contains thereon a previously prepared printed circuit.

10. A process according to Claim 1 wherein a multilayer printed circuit element is prepared comprising
    1) applying a photoadhesive layer to a previously prepared printed circuit board,
    2) exposing the photoadhesive layer to actinic radiation through an appropriate phototool in register with the underlying printed circuit,
    3) applying to the adherent image areas finely divided, solder wettable metal or alloy particles,
    4) removing any excess metal or alloy particles from the non-adherent image areas,
    5) treating the particulate metallized surface areas with solder flux and subsequently with molten solder to obtain a two-layer multilayer circuit.

11. A process according to Claim 10 wherein multilayer printed circuit elements having three or more circuit layers are prepared by repeating at least once steps 1) through 5) for each additional circuit layer using the multilayer circuit previously prepared in each subsequent step 1) and using the appropriate phototool in register with at least one of the underlying printed circuits in each step 2).

12. A process according to Claim 10 wherein holes are drilled or punched in desired junction areas of the soldered electrically conductive, multilayer printed circuit board; the holes are catalyzed with a colloidal suspension of stannous and palladium chlorides; the circuit board is cleaned to remove excess catalyst from the board side surfaces; and electroless metal plate is applied to obtain electrically conductive through holes interconnecting the multilayered printed circuit.

13. A process according to Claim 1 wherein a printed circuit containing an electrically conductive circuit trace is present on each side of a circuit board material; holes are drilled or punched in the circuit board; a photohardenable composition is applied to the surface of the circuit board and hole walls; a cover sheet is laminated to each side of the circuit board; each side of the circuit board is exposed through an image-bearing transparency to actinic radiation for the photohardenable layer; the cover sheets are removed; solder wettable metal or alloy particles, 5 to 20 microns in average diameter, are applied to the exposed surface and hole walls; the metallized printed circuit is heated, and the metallized areas and holes are treated with solder flux and subsequently with molten solder to form a soldered electrically conductive multilayer printed circuit.

14. A printed circuit element which has been produced by a process according to Claim 1 to 13 and which comprises in order,  -

(a) a substrate;

(b) an imaged layer, at least about 0.00005 inch (0.0013 mm) in thickness, of an imaged photoadhesive composition having adherent and non-adherent surface areas;

(c) finely divided, solder wettable, metal or alloy particles solely in the adherent image areas; and

(d) a layer of solder adhered to the areas having the metal or alloy particles.

15. An element according to Claim 14 wherein the substrate is paper, a paper base phenolic resin laminate, a glass cloth reinforced with epoxy resin or metal.

16. An element according to Claim 14 or 15 wherein the solder is a tin, lead combination.

17. An element according to Claim 14 wherein the photohardenable composition is a flame retardant photopolymerizable composition.

18. An element according to Claim 14 having one or more successive layers of (b), (c) and (d).

19. A printed circuit element according to Claim 14 having electrical components inserted in said element.

**Patentansprüche**

1. Verfahren zur Herstellung einer gedruckten Schaltung, die eine elektrisch leitende Schaltungsspur aus einem Material mit haftfähigen und nicht-haftfähigen Oberflächenbereichen enthält, bei dem feinteilige, durch Lot benetzbare Metall- oder Legierungsteilchen auf die Oberflächenbereiche aufgetragen und die überschüssigenMetall- oder Legierungsteilchen von den nicht-haftfähigen Oberflächenbereichen entfernt werden, dadurch gekennzeichnet, daß die aus Teilchen bestehenden metallisierten Flächen mit Lot-Flußmittel und anschließend mit geschmolzenem Lot behandelt werden, wodurch eine gelötete, elektrisch leitende Schaltung gebildet wird.

2. Verfahren nach Anspruch 1, dadurch gekennzeichnet, daß die aus Teilchen bestehenden metallisierten Flächen vor oder während der Behandlung mit dem geschmolzenen Lot gehärtet oder vulkanisiert werden.

3. Verfahren nach Anspruch 2, dadurch gekennzeichnet, daß die aus Teilchen bestehenden metallisierten Flächen durch Erhitzen, Einwirkenlassen aktinisher Strahlung oder Behandlung mit einem Härtungs- oder Vulkanisationsmittel gehärtet oder vulkanisiert werden.

4. Verfahren nach Anspruch 1, dadurch gekennzeichnet, daß die aus Teilchen bestehenden metallisierten Flächen vor der Behandlung mit dem geschmolzenen Lot auf weniger als 180°C erhitzt werden.

5. Verfahren nach Anspruch 1 oder 2, dadurch gekennzeichnet, daß die feinteiligen, durch Lot benetzbaren Metall- oder Legierungsteilchen einen mittleren Durchmesser von etwa 0,5 bis etwa 250 $\mu$m besitzen.

6. Verfahren nach Anspruch 1, dadurch gekennzeichnet, daß die Metallteilchen aus Kupfer oder einer Kupferlegierung bestehen.

7. Verfahren nach Anspruch 1, dadurch gekennzeichnet, daß die haftfähigen und nichthaftfähigen Oberflächenbereiche klebrige bzw. nicht-klebrige Oberblächenbereiche sind und in einer ein Bild tragenden Schicht einer photoklebenden Zusammensetzung vorliegen.

8. Verfahren nach Anspruch 7, dadurch gekennzeichnet, daß die Photokleber-Zusammensetzung eine lichthärtbare Zusammensetzung aus der aus photopolymerisierbaren, lichtvernetzbaren und photodimerisierbaren Zusammensetzungen bestehenden Gruppe ist.

9. Verfahren zur Herstellung einer aus mehreren Schichten bestehenden Platte mit gedruckter Schaltung nach Anspruch 1 bis 8, dadurch gekennzeichnet, daß auf dem Substrat dieser Platte mit gedruckter Schaltung eine vorher hergestellte gedruckte Schaltung enthalten ist.

10. Verfahren nach Anspruch 1, dadurch gekennzeichnet, daß ein mehrschichtiges Element mit gedruckter Schaltung hergestellt wird, indem

1) eine Photokleber-Schicht auf eine vorher hergestellte Platte mit einer gedruckten Schaltung aufgebracht wird,

2) die Photkleber-Schicht der Einwirkung aktinischer Strahlung durch eine geeignetes, an die darunter liegende gedruckte Schaltung angepaßtes Photowerkzeug hindurch ausgesetzt wird,

3) auf die haftfähigen Bildbereiche feinteilige, durch Lot benetzbare Metall- oder Legierungsteilchen aufgebracht werden,

4) sämtliche überschüssigen Metall- oder Legierungsteilchen von den nicht-haftfähigen Bildbereichen entfernt werden und

5) die aus Teilchen bestehenden Metallisierten Oberflächenbereiche mit Lot-Flußmittel und anschließend mit geschmolzenem Lot behandelt werden, wodurch eine aus zwei Schichten bestehende mehrschichtige Schaltung erhalten wird.

11. Verfahren nach Anspruch 10, dadurch gekennzeichnet, daß mehrschichtige Elemente mit gedruckter Schaltung mit drei oder mehr Schichten von Schaltungen durch mindestens einmalige Wiederholung der Schritte 1) bis 5) für jede zusätzliche Schaltungsschicht hergestellt werden, wobei die vorher hergestellte mehrschichtige Schaltung in jedem nachfolgenden Schritt 1) und das an mindestens eine der darunter liegenden gedruckten Schaltungen angepaßte Photowerkzeug in jedem Schritt 2) verwendet wird.

12. Verfahren nach Anspruch 10, dadurch gekennzeichnet, daß an den Flächen der gewünschten Verbindungen der gelöteten, elektrisch leitenden, mehrschichtigen Platte mit gedruckten Schaltungen Löcher gebohrt oder gestanzt werden, die Löcher mit einer kolloidalen Suspension von Zinn(II)- und Palladiumchlorid katalysiert werden, die Schaltungsplatte zur Entfernung des überschüssigen Katalysators von den seitlichen Oberflächen der Platte gereinigt wird und ein Verfahren zur stromlosen Metallabscheidund angewandt wird, um durch die Löcher hindurch elektrische leitende Verbindungen der mehrschichtigen gedruckten Schaltung zu erhalten.

13. Verfahren nach Anspruch 1, dadurch gekennzeichnet, daß eine eine elektrisch leitende Schaltungsspur enthaltende gedruckte Schaltung auf jeder Seite eines Materials einer Schaltungsplatte vorhanden ist, Löcher in die Schaltungsplatte gebohrt oder gestanzt werden, eine lichthärtbare Zusammensetzung auf die Oberfläche der Schaltungsplatte und die Wandungen der Löcher aufgebracht wird, eine Deckfolie auf jede Seite der Schaltungsplatte auflaminiert wird, jede Seite der Schaltungsplatte durch eine transparente Bildvorlage hindurch der Einwirkung aktinischer Strahlung auf die lichthärtbare Schicht ausgesetzt wird, die Deckfolien entfernt werden, durch Lot benetzbare Metall- oder Legierungsteilchen mit einem Durchmesser von 5 bis 20 $\mu$m auf die exponierte Oberfläche und die exponierten Lochwandungen aufgebracht werden, die metallisierte gedruckte Schaltung erhitzt wird und die metallisierten Bereiche und Löcher mit Lot-Flußmittel und anschließend geschmolzenem Lot behandelt werden, wodurch eine gelötete, elektrisch leitende mehrschichtige gedruckte Schaltung erhalten wird.

14. Element mit gedruckter Schaltung, dadurch gekennzeichnet, daß es mittels eines Verfahrens nach Anspruch 1 bis 13 hergestellt wurde und, in der angegebenen Reihenfolge,

   (a) ein Substrat,

   (b) eine ein Bild tragende Schicht, mindestens etwa 0,00005 Zoll (0,0013 mm) dick, einer ein Bild tragenden photoklebenden Zusammensetzung mit haftfähigen und nicht-haftfähigen Oberflächenbereichen,

   (c) feinteilige, durch Lot benetzbare Metall-oder Legierungsteilchen allein in den haftfähigen Bildbereichen und

   (d) eine Lot-schicht haftend an den Flächen, auf denen sich die Metall- oder Legierungsteilchen befinden,

umfaßt.

15. Element nach Anspruch 14, dadurch gekennzeichnet, daß das Substrat Papier, ein Phenol-Harz-Laminat auf Papier-Grundlage, ein mit Epoxy-Harz verstärktes Glasgewebe oder Metall ist.

16. Element nach Anspruch 14 oder 15, dadurch gekennzeichnet, daß das Lot eine Kombination aus Zinn und Blei ist.

17. Element nach Anspruch 14, dadurch gekennzeichnet, daß die lichthärtbare Zusammensetzung eine Flammwidrige, photopolymerisierbare Zusammensetzung ist.

18. Element nach Anspruch 14, dadurch gekennzeichnet, daß es eine oder mehrere aufeinander folgende Schichten (b), (c) und (d) besitzt.

19. Element mit gedruckter Schaltung nach Anspruch 14, dadurch gekennzeichnet, daß elektrische Komponenten in das Element eingefügt sind.

**Revendications**

1. Un procédé de production d'un circuit imprimé contenant un tracé de circuit électriquement conducteur à partir d'une matière ayant des zones de surface adhérentes et non adhérentes, selon lequel on applique des particules de métal ou d'alliage finement divisées, mouillables par la soudure, sur les zones de surface; on enlève des zones non adhérentes toutes particules de métal ou d'alliage en excès; caractérisé en ce que les zones métallisées par les particules sont traitées par un flux de soudure et ensuite par de la soudure fondue de manière à former un circuit soudé électriquement conducteur.

2. Un procédé selon la revendication 1, dans lequel les zones métallisées par les particules sont durcies avant ou pendant le traitement par la soudure fondue.

3. Un procédé selon la revendication 2, dans lequel les zones métallisées par les particules sont durcies par chauffage, par exposition à une radiation actinique ou par traitement par un agent de durcissement.

4. Un procédé selon la revendication 1, dans lequel les zones métallisées par les particules sont chauffées à moins de 180°C avent traitement par la soudure fondue.

5. Un procédé selon la revendication 1 ou 2, caractérisé en ce que les particules finement divisées de métal ou d'alliage mouillables par la soudure ont un diamètre moyen d'environ 0,5 à environ 250 micromètres.

6. Un procédé selon la revendication 1, dans lequel les particules de métal sont des particules de cuivre ou d'un alliage de cuivre.

7. Un procédé selon la revendication 1, dans lequel les zones de surface adhérentes et non adhérentes sont des zones de surface poisseuses et non poisseuses, respectivement, et sont présentes dans une couche porteuse d'image de composition photo-adhésive.

8. Un procédé selon la revendication 7, dans lequel la composition photo-adhésive est une composition photodurcissable choisie parmi les compositions photopolymérisables, photoréti-culables et photodimérisables.

9. Un procédé pour la préparation d'un panneau à circuit imprimé à couches multiples selon l'une des revendications 1 à 8, dans lequel le panneau à circuit imprimé porte un circuit imprimé préparé précédemment.

10. Un procédé selon la revendication 1, dans lequel on prépare un panneau à circuit imprimé à couches multiples, qui comprend les étapes qui consistent à

1) appliquer une couche photo-adhésive sur un panneau à circuit imprimé préparé précédemment,

2) exposer la couche photo-adhésive à une radiation actinique à travers un outil photographique approprié en alignement avec le circuit imprimé sous-jacent,

3) appliquer sur les zones d'image adhérentes des particules finement divisées de métal ou d'alliage mouillables par la soudure,

4) enlever des zones d'image non adhérentes toutes particules de métal ou d'alliage en excès,

5) traiter les zones métallisées par les particules au moyen d'un flux de soudure et ensuite de soudure fondue de manière à obtenir un circuit multicouches à deux couches.

11. Un procédé selon la revendication 10, dans lequel on prépare des éléments à circuits imprimés multicouches ayant trois couches de circuit ou plus en répétant au moins une fois les étapes 1) à 5) pour chaque couche de circuit supplémentaire en utilisant le circuit multicouches préparé précédemment dans chaque étape 1) suivante et en utilisant l'outil photographique approprié en alignement avec au moins un des circuits imprimés sous-jacents dans chaque étape 2).

12. Un procédé selon la revendication 10, dans lequel des trous sont percés ou formés à l'emporte-pièce dans des zones de jonction désirées du panneau à circuit imprimé à couches multiples électriquement conducteur soudé; les trous sont catalysés par une suspension colloïdale de chlorures stanneux et de palladium; le panneau à circuit est nettoyé pour enlèvement du catalyseur en excès des surfaces des côtés du panneau; et on applique un revêtement métallique non électrolytique pour obtenir des trous de traversée électriquement conducteurs interconnectant le circuit imprimé multicouches.

13. Un procédé selon la revendication 1, dans lequel un circuit imprimé contenant un tracé de circuit électriquement conducteur est présent de chaque côté d'une matière pour panneau à circuit; des trous sont percés ou formés à l'emporte-pièce dans le panneau à circuit; une composition photodurcissable est appliquée sur la surface du panneau à circuit et les parois du trou; une feuille protectrice est stratifiée de chaque côté du panneau à circuit; chaque côté du panneau à circuit est exposé à travers un élément transparent porteur d'image à une radiation actinique pour la couche photodurcissable; les feuilles protectrices sont enlevées; des particules de métal ou d'alliage mouillables par la soudure, de 5 à 20 micromètres de diamètre moyen, sont appliquées sur la surface exposée et les parois des trous; le circuit imprimé métallisé est schauffé et on traite les zones métallisées et les trous par un flux de soudure et ensuite par de la soudure fondue pour former un circuit imprimé à couches multiples électriquement conducteur soudé.

14. Un panneau à circuit imprimé qui a été produit par un procédé selon l'une des revendications 1 à 13 et qui comprend, dans l'ordre:

(a) un substrat,

(b) une couche porteuse d'image, d'au moins environ 0,0013 mm d'épaisseur, d'une composition photo-adhésive porteuse d'image ayant des zones de surface adhérentes et non adhérentes;

(c) des particules finement divisées de métal ou d'alliage, mouillables par la soudure, uniquement dans les zones d'image adhérentes; et

(d) une couche de soudure adhérente aux zones ayant les particules de métal ou d'alliage.

15. Un élément selon la revendication 14, dans lequel le substrat est du papier, un stratifié de résine phénolique à support de papier, un tissu de fibre de verre renforcé par une résine époxy, ou un métal.

16. Un élément selon la revendication 14 ou 15, dans lqeuel la soudure est une combinaison d'étain et de plomb.

17. Un élément selon la revendication 14, dans lequel la composition photodurcissable est une composition photopolymérisable ignifugée.

18. Un élément selon la revendication 14 ayant une ou plusierurs couches successives de (b), (c) et (d).

19. Un élément a circuit imprimé selon la revendication 14 ayant des composants électriques insérés dans l'élément.